# EUROPÄISCHE PATENTSCHRIFT

(11) **EP 2 141 406 B1**
(45) Veröffentlichungstag und Bekanntmachung des Hinweises auf die Patenterteilung: **18.04.2012**
(21) Anmeldenummer: 09008505.1
(22) Anmeldetag: 30.06.2009
(51) Int. Cl.: F21S 8/10, F21V 19/00, H05K 1/02

(54) **Leuchte**
Lamp
Eclairage

(30) Priorität: 04.07.2008 DE 102008031432
(43) Veröffentlichungstag der Anmeldung: 06.01.2010
(73) Patentinhaber: odelo GmbH, 71409 Schwaikheim (DE)
(72) Erfinder: Rommel, Bernd, 70736 Fellbach (DE); Schwegler, Veit, Dr., 70372 Stuttgart (DE); Vlastnik, Andreas, 71640 Ludwigsburg (DE)
(74) Vertreter: Meyer, Thorsten

(56) Entgegenhaltungen:
- EP-A1- 1 867 912
- EP-A2- 0 921 568
- EP-A2- 0 972 677
- EP-A2- 0 980 788
- DE-A1- 4 242 842
- DE-A1- 4 416 986
- DE-A1- 10 308 917
- DE-A1- 19 734 748

## Beschreibung

Die Erfindung betrifft eine Leuchte gemäß dem Oberbegriff des Anspruchs 1.

Eine Leuchte erfüllt z.B. bei einem Kraftfahrzeug je nach Ausgestaltung verschiedene Aufgaben bzw. Funktionen, wie beispielsweise bei einer Ausgestaltung als Scheinwerfer eine die Fahrbahn ausleuchtende Funktion, oder bei einer Ausgestaltung als Signalleuchte eine Signalfunktion, wie beispielsweise zur Fahrtrichtungsanzeige oder Anzeige einer Bremstätigkeit, oder einer Sicherstellung einer Sichtbarkeit des Kraftfahrzeugs bei Tag und/oder Nacht. Beispiele für Leuchten sind am Fahrzeugbug, an den Fahrzeugflanken und/oder an den Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine Leuchte z.B. für ein Kraftfahrzeug besteht im Wesentlichen aus einem Gehäuse, einem darin angeordneten Reflektor, einem typischerweise vor dem Reflektor angeordneten Leuchtmittel, sowie einer den Reflektor und das Leuchtmittel gegen Witterungseinflüsse schützenden, kurz auch als Lichtscheibe bezeichneten transparenten Abdeckung, welche gemeinsam mit dem Gehäuse einen den Reflektor und das Leuchtmittel aufnehmenden Raum umschließt. Das Gehäuse bzw. der Raum kann dabei in mehrere Kammern mit jeweils eigenen Leuchtmitteln, Reflektoren sowie gegebenenfalls Lichtscheiben unterteilt sein, von denen jede Kammer eine oder mehrere andere der oben beschriebenen Funktionen erfüllen kann.

Als Leuchtmittel kommen z.B. in Kraftfahrzeugen beispielsweise Glühlampen, Gasentladungslampen und vermehrt auch einzeln oder gruppenweise angeordnete Lichtemittierende Dioden (LEDs), bestehend aus einem LED-Halbleiter-Chip, kurz LED-Chip, sowie einer beispielsweise durch Spritzgießen angeformten, den LED-Chip ganz oder teilweise umhüllenden Primäroptik, zum Einsatz. Auch sind Leuchten bekannt, in denen reine LED-Chips ohne angeformte Primäroptiken zum Einsatz kommen.

Werden mehrere bzw. gruppenweise angeordnete LEDs als Leuchtmittel verwendet, so wird typischerweise ein Reflektor mit mehreren Reflektorkammern verwendet, wobei im Brennpunkt jeder Reflektorkammer eine LED angeordnet ist. Um die LEDs gegenüber dem Reflektor zu positionieren werden diese auf einem LED-Träger angeordnet, welcher zur Aufnahme, Befestigung und elektrischen Kontaktierung der LEDs dient. Darüber hinaus können auf dem LED-Träger weitere benötigte Elektronikbauteile, Widerstände etc. befestigt sein. Kabel und/oder Stecker zur weiterführenden elektrischen Kontaktierung sind auch an dem LED-Träger befestigt. Der LED-Träger wird normalerweise am Reflektor befestigt oder zumindest positioniert und gewährleistet dadurch eine genaue Lage der LEDs zum Brennpunkt in den einzelnen Reflektorkammern.

Ein LED-Träger nach dem Stand der Technik umfasst einen rahmen- oder leiterartigen Kunststoffträger, eine oder mehrere in den Kunststoffträger einsetzbare LED-Trägerplatinen, sowie eine zugehörige Verdrahtung der LED-Trägerplatinen untereinander.

Der rahmen- oder leiterartige Kunststoffträger des LED-Trägers ist beispielsweise als Spritzgussteil hergestellt und weist Aufnahmen in Form von z.B. schlitzförmigen Ausnehmungen zum Einschieben von LED-Trägerplatinen auf. Die einzelnen LED-Trägerplatinen können von einer Seite her in eine jeweils zugeordnete Aufnahme eingeschoben werden und beispielsweise in den Aufnahmen verrasten.

Die LED-Trägerplatinen sind üblicherweise als ebene Platten ausgeführt, wodurch eine LED-Trägerplatine jeweils nur in einer Ebene liegende LEDs tragen kann. Die LED-Trägerplatinen sind durch Kabel elektrisch miteinander verbunden.

Insbesondere bei neuen Leuchten für Kraftfahrzeuge, welche oftmals an komplexe Karosserieformen angepasst sein müssen, genügt eine Anordnung in einer Ebene nicht, um eine durch die Form der Leuchte vorgegebene räumliche Verteilung der LEDs zu erhalten.

Um die LEDs in verschiedenen Ebenen im Raum anzuordnen sind deshalb entweder in einem aufwändigen Prozess aus mehreren einzelnen ebenen Platten zusammengesetzte LED-Trägerplatinen und/oder eine Vielzahl von einzelnen LED-Trägerplatinen notwendig, die dann in dem Kunststoffträger des LED-Trägers gehalten werden müssen. Diese einzelnen LED-Trägerplatinen müssen elektrisch leitend miteinander durch Kabel verbunden werden. Dies ist sehr aufwändig und birgt viele Fehlermöglichkeiten in sich, wie beispielsweise falsche Kontaktierung oder Einklemmen und Beschädigen von Kabeln, sowie eine Vielzahl von Steck- und Lötverbindungen mit den damit verbundenen Fehlerquellen. Auch ist die Montage sehr aufwändig und fehleranfällig.

Eine andere Technologie ist die Folientechnologie. Dabei werden Surface Mounted Device (SMD) LED-Halbleiter-Chips auf Folien aufgelötet, die dann anstelle der LED-Trägerplatinen auf dem Kunststoffträger des LED-Trägers angeordnet werden.

Eine Leuchte mit in Folientechnologie elektrisch kontaktierten LED-Chips ist beispielsweise durch DE 200 01 407 U1 bekannt.

Oberflächenmontierbare Bauteile bzw. SMDs haben im Gegensatz zur Durchsteckmontage bzw. Durchkontaktierung keine Drahtanschlüsse bzw. keine Bedrahtung, sondern werden mittels lötfähiger Anschlussflächen direkt auf die Leiterbahnen einer Flachbaugruppe, etwa eine Platine oder eine Folie gelötet. SMD-Bauteile werden in der Regel im Reflow-Verfahren verlötet. Zunächst wird dabei eine Flachbaugruppe im Sieb- bzw. Schablonendruck mit Lotpaste bedruck. Anschließend wird die Flachbaugruppe mit den SMDs bestückt. Dann kommt die bedruckte und bestückte Flachbaugruppe in einen Ofen, wo sie zumindest von der mit Lotpaste bedruckten Seite her erhitzt wird.

Nachteile der SMD-Technik sind, dass spezielle Geräte für die Bestückung der Platine erforderlich sind. Darüber hinaus können SMD-Bauteile durch mechanische Belastung eher abgelöst bzw. vorgeschädigt oder beschädigt werden als bedrahtete Bauteile. Durch den Reflow-Lötprozess erhalten die kompletten SMD-Bauteile eine kurze hohe Temperaturbelastung von über 200 bis 250°C. Im Vergleich dazu ist die Temperaturbelastung bei bedrahteten Bauelementen, die nur auf der dem Bauteil abgewandten Unterseite einer Platine verlötet werden, indem sie beispielsweise mit einer Lötwelle in Kontakt kommen, viel geringer.

Hieraus ist ersichtlich, dass die Folientechnologie sehr aufwändig und teuer ist. Die Folie oder Folien mit LED-Chips müssen außerdem wiederum auf einem Kunststoffträger befestigt werden. Die genaue Positionierung der LED-Chips ist bei der Folientechnologie auch sehr aufwendig.

Darüber hinaus können bei der Folientechnologie auch nur SMD LED-Halbleiter-Chips verarbeitet werden. Diese weisen den Nachteil auf, dass sie nicht mit z.B. durch Spritzgießen direkt angesetzten Primäroptikkörpern versehen werden können, wodurch das Licht von SMD-Halbleiter-Chips weniger gerichtet ist und damit im Vergleich zu bedrahteten LEDs mit z.B. im Spritzgussverfahren vorgesetzter Primäroptik nur eine geringere Lichtausbeute erreicht wird.

Durch die gattungsgemäße DE 197 34 748 A1 sind zwei Ausführungen einer Leuchte mit mehreren auf einem LED-Träger angeordneten LEDs bekannt. Den beiden Ausführungen ist gemein, dass die Leuchte einen Reflektor mit mehreren Reflektorkammern hat. Im Brennpunkt jeder Reflektorkammer ist eine LED angeordnet. Der LED-Träger weist mehrere mit jeweils einer oder mehreren LEDs bestückte ebene Flächenabschnitte auf. Die Flächenabschnitte, die beispielsweise auch gewölbt ausgeführt sein können, können unterschiedliche Raumpositionen und/oder Raumorientierungen einnehmen. Über Leiterbahnen sind die LEDs elektrisch kontaktiert. Gemäß der ersten Ausführung ist der LED-Träger als Kunststoffspritzteil mit in das Kunststoffspritzteil integrierten Leiterbahnen hergestellt, wobei hierbei die Leiterbahnen von dem Kunststoff umspritzt und von dem Kunststoff umschlossen sind. Nachteilig hieran ist, dass aufgrund des Umstands des Umspritzens der in das Kunststoffspritzteil integrierten Leiterbahnen weder eine leicht zugängliche Anordnung der Leiterbahnen auf der Vorderseite, noch auf der Rückseite des LED-Trägers zulassen. Dadurch ist der elektrische Kontakt zwischen den Leiterbahnen und den LEDs nur sehr schwierig herzustellen. Gemäß der zweiten Ausführung ist der LED-Träger als Kunststoffspritzteil mit darauf aufgebrachten Leiterbahnen hergestellt. Die Leiterbahnen können entweder
- auf der dem Reflektor abgewandten Rückseite des LED-Trägers angeordnet sein, wobei die LEDs mit Beinchen versehene, bedrahtete LEDs sind und mittels Durchkontaktierung auf der Rückseite des LED-Trägers mit den Leiterbahnen verschweißt sind, oder
- auf der dem Reflektor zugewandten Vorderseite des LED-Trägers angeordnet sein, wobei in diesem Fall die LEDs mit Beinchen versehene, bedrahtete LEDs sind, welche rechtwinklig abgewinkelt und auf der Vorderseite des LED-Trägers flächig mit den Leiterbahnen verschweißt sind.

Eine Technik, die geeignet scheint, fast beliebig geformte LED-Träger herzustellen, ist die Molded Interconnect Devices (MID) Technik.

Beispielsweise ebenfalls durch DE 200 01 407 U1 ist bekannt, in Leuchten LED-Chips mittels in MID Technik hergestellter LED-Träger elektrisch zu kontaktieren.

Durch die DE 103 08 917 A1 ist ferner bekannt, ein optoelektronisches Bauteil in MID Technik herzustellen, indem in eine als Reflektor ausgebildete Ausnehmung eines in MID Technik hergestellten Gehäuses ein LED-Chip eingesetzt wird. Die Reflektorflächen des Reflektors sind dabei mit einer Metallisierung versehen, die zur Übernahme einer elektrischen Funktion bestimmt ist.

Die in Verbindung mit MID Technik verwendeten LED-Chips verfügen ebenso wie die SMD LED-Chips über keine beispielsweise im Spritzgussverfahren hergestellten speziellen Optiken, wie beispielsweise Primäroptiken. Diese würden darüber hinaus bei den zur Befestigung mit den in MID Technik hergestellten Trägern und elektrischen Verbindung mit den dabei ausgebildeten Leiterbahnen nach den nach dem Stand der Technik erforderlichen Verfahren Schaden nehmen, wodurch sie unbrauchbar werden würden.

Durch EP 0 972 677 A2 ist bekannt, bei einer Leuchte mit mehreren LEDs die LEDs von der Rückseite eines LED-Trägers her kommend durch Öffnungen im LED-Träger zu stecken und mittels eines Klebers zu fixieren. Abgewinkelte Beinchen der LEDs werden zu deren elektrischer Kontaktierung im Anschluss an das Verkleben mit Bond- bzw. Kontaktdrähten auf der Rückseite mittels Laserstrahl verlötet oder verschweißt.

Durch EP 0 980 788 A2 ist eine Leuchte mit mehreren auf einem LED-Träger angeordneten LEDs bekannt. Die Leuchte hat einen Reflektor mit mehreren Reflektorkammern. Im Brennpunkt jeder Reflektorkammer ist eine LED angeordnet. Der LED-Träger besteht aus mehreren mittels flexibler Leiterbahnen elektrisch miteinander verbundenen, ebenen Trägerplatten, auf denen die LEDs aufgelötet sind.

Der Erfindung liegt die Aufgabe zugrunde, eine Leuchte mit einem LED-Träger zu entwickeln, die einfach hergestellt werden kann und bei der darüber hinaus eine Beschädigung der LEDs sowohl während der Herstellung, als auch während des Betriebs wirkungsvoll verhindert wird.

Die Aufgabe wird gelöst durch die Merkmale des Anspruchs 1.

Bei einer beispielsweise als Heckleuchte für Kraftfahrzeuge ausgeführten Leuchte mit mehreren auf einem LED-Träger angeordneten LEDs und einem Reflektor mit mehreren Reflektorkammern, wobei im Brennpunkt jeder Reflektorkammer eine LED angeordnet ist, ist demnach zum Einen vorgesehen, dass der LED-Träger als Kunststoffspritzteil in Molded Interconnect Devices (MID) Technik hergestellt ist, mit in das Kunststoffspritzteil integrierten Leiterbahnen, über die die LEDs elektrisch kontaktiert sind bzw. mit denen die LEDs elektrisch leitend verbunden sind. Dadurch können komplexe Formen hergestellt werden und die einzelnen LEDs können fast beliebig, beispielsweise in mehreren unterschiedlichen Ebenen, die darüber hinaus auch versetzt sein und/oder einander schneidend verlaufen können, im Raum positioniert werden. Zum Anderen sind die Leiterbahnen auf der dem Reflektor abgewandten Rückseite des LED-Trägers angeordnet, wobei es sich bei den LEDs um mit Beinchen versehene, bedrahtete LEDs handelt, welche mittels Durchkontaktierung durch Bestückungslöcher geführt auf der Rückseite des LED-Trägers mit den Leiterbahnen verlötet sind. Die elektrische Kontaktierung der LEDs und gegebenenfalls weiterer Bauteile erfolgt dabei über die in MID-Technik integrierten Leiterbahnen auf der den LEDs und damit dem Reflektor abgewandten Rückseite des als Kunststoffspritzteil ausgeführten LED-Trägers. Da die Kontaktierung und Lötung dann auf der den LEDs abgewandten, gegenüberliegenden Seite des Trägers erfolgt, kann der eigentliche Lötprozess z.B. über Reflow Löten erfolgen. Der hauptsächliche Wärmeeintrag für das Löten erfolgt somit auf der den LEDs abgewandten Rückseite des LED-Trägers. Die LEDs werden dadurch beim Lötprozess durch den LED-Träger von der Wärme abgeschirmt und werden dadurch nicht beschädigt. Dadurch können mit Beinchen sowie gegebenenfalls bereits mit beispielsweise im Spritzgussverfahren hergestellten speziellen Optiken, beispielsweise Primäroptiken, versehene bedrahtete LEDs in Verbindung mit der MID-Technik verarbeitet werden, obwohl in Verbindung mit der MID-Technik nach dem Stand der Technik bislang nur SMD LED-Halbleiter-Chips und SMD-Bauteile verarbeitet werden können.

Darüber hinaus ist vorgesehen, dass die Beinchen der bedrahteten LEDs auf der Rückseite des LED-Trägers umgebogen und zur wärmetechnischen Anbindung flach auf eine auf der Rückseite angeordnete Kontaktfläche gelegt sind. Die LED Beinchen auf der Rückseite des LED-Trägers können nach dem Bestücken umgebogen werden, damit diese bis zum Löten fixiert sind und nicht herausfallen können. Auch kann bei einer entsprechenden Länge der Beinchen, bei welcher Länge die Beinchen vorzugsweise um 90° gebogen und flach auf die LED-Träger Rückseite gelegt werden können, eine gute wärmetechnische Anbindung an eine entsprechend große Kontaktfläche z.B. aus Kupfer erfolgen. Dies ist wichtig für eine gute Wärmeabfuhr der LEDs und eine dadurch geringe Degradation.

Weitere Vorteile der Erfindung gegenüber dem Stand der Technik ergeben sich beispielsweise dadurch, dass die LEDs über den als Kunststoffspritzteil in MID-Technik ausgeführten LED-Träger fast beliebig im Raum und sehr genau positioniert werden können. Es sind keine einzelnen Platinen und Kabelverbindungen notwendig.

So ist beispielsweise denkbar, dass der LED-Träger mindestens zwei mit jeweils mindestens einer LED bestückte Flächenabschnitte aufweist, welche unterschiedliche Raumpositionen und/oder Raumorientierungen einnehmen. Die Flächenabschnitte können gewölbt sein bzw. können gewölbt verlaufen. Alternativ oder zusätzlich können die Flächenabschnitte in sich tordiert bzw. verdreht sein bzw. in sich tordiert bzw. verdreht verlaufen. Auch können die Flächenabschnitte Ebenen sein. Die Erfindung erlaubt ferner, dass die Flächenabschnitte dem Verlauf einer Lichtscheibe und/oder des Reflektors der Leuchte sowie gegebenenfalls dessen Reflektorkammern angepasst sind. Auch können die Flächenabschnitte einander schneiden und/oder zumindest abschnittsweise parallel verlaufen. Beispielsweise können zwischen den Flächeabschnitten Stufen vorgesehen sein, über welche Stufen die Flächenabschnitte miteinander verbunden sind.

Als MID-Technik kommen beispielsweise der Zweikomponentenspritzguss, das Heißprägen, das Maskenbelichtungsverfahren, die Laserstrukturierung und das Folienhinterspritzen in Frage, also wahlweise sowohl subtraktiv strukturierende, als auch additiv metallisierenden Verfahren. Vom Zweikomponentenspritzguss existieren dabei eine Vielzahl von Varianten, welche grundsätzlich alle zur Herstellung des LED-Trägers der erfindungsgemäßen Leuchte denkbar sind. Am gebräuchlichsten sind das PCK (Printed Circuit Board Kollmorgen)- und das SKW (Sankyo Kasei Wiring Board)-Verfahren. Auch bei der Laserstrukturierung sind unterschiedliche Verfahren bekannt, die Laserdirektstrukturierung und die subtraktive Laserstrukturierung.

Bei der Durchkontaktierung werden im Gegensatz zur SMD-Technik die Anschlussdrähte einer bedrahteten LED durch Bestückungslöcher geführt, und auf der Rückseite des LED-Trägers verlötet. Normalerweise können bedrahtete LEDs wegen fehlender Temperaturbeständigkeit nur konventionell mit Platinen und Wellenlöten verarbeitet werden. Durch die erfindungsgemäße Anordnung der in MID-Technik in bzw. auf den LED-Träger integrierten Leiterbahnen auf der den LEDs und damit dem Reflektor abgewandten Rückseite des LED-Trägers, können nunmehr auch bedrahtete LEDs z.B. im Reflow Verfahren verlötet werden.

Eventuell benötigte weitere elektronische Bauteile können dabei auf der dem Reflektor abgewandten Rückseite des LED-Trägers befestigt werden. Diese sind dann vorzugsweise als SMD Bauteile ausgeführt.

Bei den bedrahteten LEDs handelt es sich vorzugsweise um spritzgegossene LEDs mit speziellen Optiken, beispielsweise Licht bündelnden oder Licht streuenden oder gezielt Licht beispielsweise in einen Reflektor oder eine Reflektorkammer oder Partien hiervon umlenkenden bzw. einkoppelnden Primäroptiken. Bei der erfindungsgemäßen Leuchte ist es möglich, bedrahtete LEDs, insbesondere spritzgegossene LEDs mit teilweise angespritzten speziellen Optiken, auch in anderen Lötverfahren, z.B. Reflow, und in Verbindung mit MID Technik zu verarbeiten.

Eine vorteilhafte Ausgestaltung der Erfindung sieht vor, dass der Reflektor und der LED-Träger ein in MID-Technik hergestelltes integrales Bauteil sind. Beispielsweise kann der LED-Träger Teil eines in MID-Technik hergestellten Reflektors sein.

Alternativ kann der LED-Träger am Reflektor befestigt oder zumindest positioniert sein.

Weitere denkbare Ausgestaltungen der Erfindung sehen beispielsweise vor, dass der Reflektor verspiegelt ist. Ferner können an einer beliebigen Stelle auf dem LED-Träger weitere elektronische Bauteile, wie etwa Widerstände oder dergleichen, befestigt sein.

Die erfindungsgemäße Leuchte kann darüber hinaus in mehrere Kammern mit jeweils eigenen LEDs und Reflektoren mit mehreren Reflektorkammern unterteilt sein, von denen jede Kammer die Selbe oder unterschiedliche der eingangs beschriebenen Funktionen erfüllt.

Die Erfindung wird nachfolgend anhand eines in den Zeichnungen dargestellten Ausführungsbeispiels näher erläutert. Es zeigen:
- Fig. 1: eine schematische Darstellung eines Reflektors und eines LED- Trägers einer erfindungsgemäßen Leuchte in Einbaulage relativ zueinander in einer perspektivischen Ansicht.
- Fig. 2: eine perspektivische Ansicht des LED-Trägers aus Fig. 1 mit darauf angeordneten LEDs von seiner dem Reflektor zugewandten Vorderseite.
- Fig. 3: eine perspektivische Ansicht des LED-Trägers aus Fig. 1 mit darauf angeordneten LEDs von seiner dem Reflektor abgewandten Rückseite.

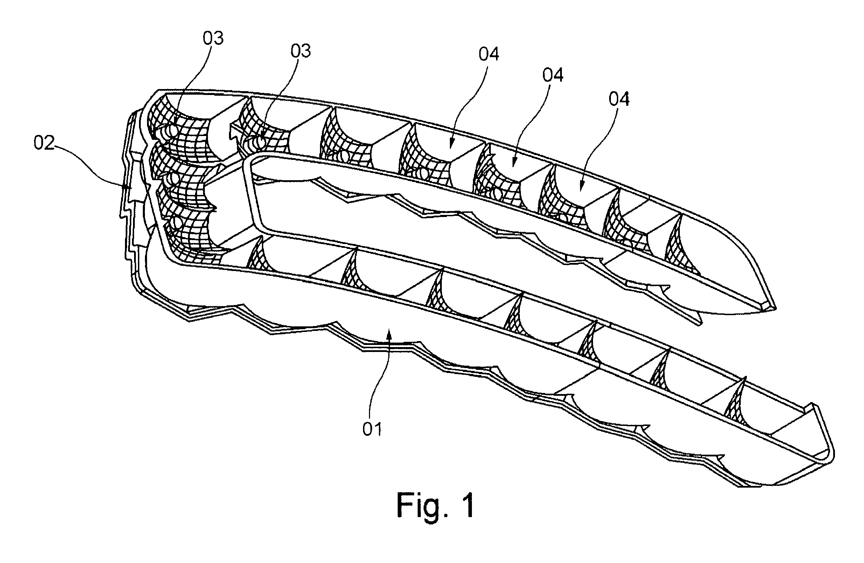

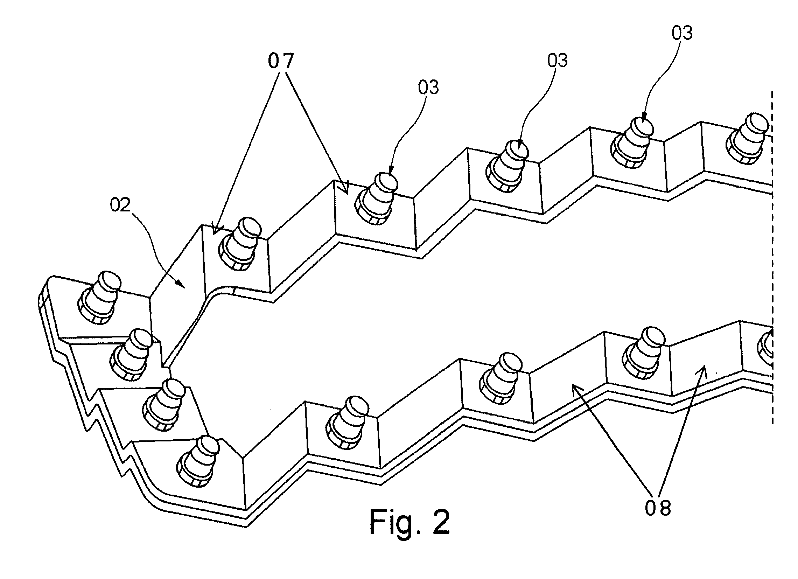

Eine beispielsweise als Heckleuchte für Kraftfahrzeuge ausgeführte erfindungsgemäße Leuchte umfasst im Wesentlichen einen in den Fig. 1 bis 3 dargestellten LED-Träger 02 mit mehreren auf dem LED-Träger 02 angeordneten LEDs 03 und einen nur in Fig. 1 dargestellten Reflektor 01 mit mehreren Reflektorkammern 04. Im Brennpunkt jeder Reflektorkammer 04 ist eine LED 03 angeordnet. Der LED-Träger 02 ist als Kunststoffspritzteil in Molded Interconnect Devices (MID) Technik hergestellt, mit in das Kunststoffspritzteil integrierten Leiterbahnen 06, über die die LEDs 03 elektrisch kontaktiert sind bzw. mit denen die LEDs 03 elektrisch leitend verbunden sind. Dadurch können komplexe Formen hergestellt werden und die einzelnen LEDs 03 können fast beliebig im Raum positioniert werden. Ferner sind im Vergleich zum Stand der Technik keine einzelnen Platinen und Kabelverbindungen notwendig.

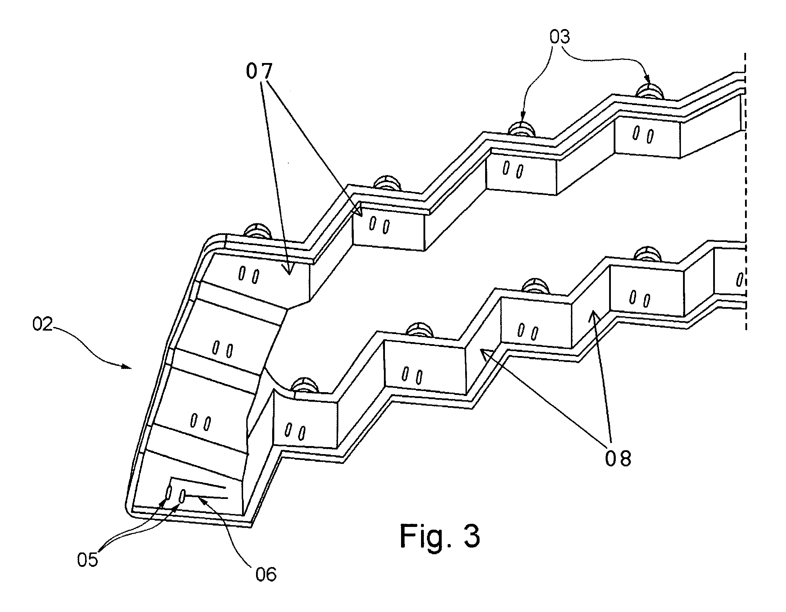

Die Leiterbahnen 06 sind vorzugsweise auf der dem Reflektor 01 abgewandten, in Fig. 3 gezeigten Rückseite des LED-Trägers 02 angeordnet. Die LEDs 03 sind mit Beinchen 05 versehene, so genannte bedrahtete LEDs 03, welche mittels Durchkontaktierung durch Bestückungslöcher geführt auf der Rückseite des LED-Trägers 02 mit den Leiterbahnen 06 verlötet sind. Die elektrische Kontaktierung der LEDs 03 und gegebenenfalls weiterer Bauteile erfolgt dabei über die in MID-Technik integrierten Leiterbahnen 06 auf der den LEDs 03 und damit dem Reflektor 01 abgewandten Rückseite des als Kunststoffspritzteil ausgeführten LED-Trägers 02. Da die Kontaktierung und Lötung dann auf der den LEDs 03 gegenüberliegenden Rückseite des LED-Trägers 02 erfolgt, kann der eigentliche Lötprozess z.B. über Reflow Löten erfolgen. Die LEDs werden dadurch beim Lötprozess durch den LED-Träger von der Wärme abgeschirmt und werden dadurch nicht beschädigt. Dadurch können bedrahtete LEDs in Verbindung mit der MID-Technik verarbeitet werden, obwohl in Verbindung mit der MID-Technik bislang nur SMD LED-Halbleiter-Chips und SMD-Bauteile verarbeitet werden können.

Eventuell benötigte weitere elektronische Bauteile können ebenfalls auf der dem Reflektor abgewandten Rückseite des LED-Trägers 02 befestigt werden. Diese elektronischen Bauteile sind vorzugsweise als SMD Bauteile ausgeführt.

Bei den bedrahteten LEDs 03 handelt es sich vorzugsweise um spritzgegossene LEDs 03 mit speziellen Optiken.

Die Beinchen 05 der bedrahteten LEDs 03 sind auf der Rückseite des LED-Trägers 02 umgebogen und zur wärmetechnischen Anbindung flach auf eine auf der Rückseite angeordnete Kontaktfläche gelegt. Dies ist wichtig für eine gute Wärmeabfuhr der LEDs 03 und eine dadurch geringe Degradation.

Der LED-Träger 02 ist vorzugsweise am Reflektor 01 befestigt oder zumindest positioniert. Der Reflektor ist vorzugsweise verspiegelt.

Der LED-Träger 02 weist mehrere mit jeweils beispielsweise einer LED 03 bestückte Flächenabschnitte 07 auf, welche unterschiedliche Raumpositionen einnehmen. Auch können die Flächeabschnitte 07 unterschiedliche Raumorientierungen einnehmen, beispielsweise wenn es erforderlich ist, dass z.B. einzelne LEDs 03 aufgrund einer anderen Abstrahlrichtung beispielsweise zugehöriger Reflektorkammern, unterschiedlich ausgerichtet angeordnet sein müssen, als Beispielsweise das Gros der auf einem LED-Träger 02 angeordneten LEDs 03. Zwischen den Flächeabschnitten 07 können Stufen 08 vorgesehen sein, über welche Stufen 08 die Flächenabschnitte 07 miteinander verbunden sind.

Die Erfindung ist insbesondere im Bereich der Herstellung von Leuchten für Kraftfahrzeuge gewerblich anwendbar.

### Bezugszeichenliste

- 01: Reflektor
- 02: LED-Träger
- 03: LED
- 04: Reflektorkammer
- 05: Beinchen
- 06: Leiterbahn
- 07: Flächeabschnitt
- 08: Stufe

## Patentansprüche

1. Leuchte mit mehreren auf einem LED-Träger (02) angeordneten LEDs (03) und einem Reflektor (01) mit mehreren Reflektorkammern (04), wobei:
- im Brennpunkt jeder Reflektorkammer (04) eine LED (03) angeordnet ist,
- der LED-Träger (02) als Kunststoffspritzteil hergestellt ist,
- der LED-Träger (02) mit Leiterbahnen (06) versehen ist, über welche die LEDs (03) elektrisch kontaktiert sind,
- die Leiterbahnen (06) auf der dem Reflektor (01) abgewandten Rückseite des LED-Trägers (02) angeordnet sind,
- die LEDs (03) mit Beinchen (05) versehene, bedrahtete LEDs (03) sind, und
- die LEDs (03) mittels Durchkontaktierung auf der Rückseite des LED-Trägers (02) mit den Leiterbahnen (06) elektrisch verbunden sind,
**dadurch gekennzeichnet, dass**:
- der LED-Träger (02) in Molded Interconnect Devices (MID) Technik mit in das Kunststoffspritzteil integrierten Leiterbahnen (06)hergestellt ist,
- die LEDs (03) mit den Leiterbahnen (06) verlötet sind,
- die Beinchen (05) der bedrahteten LEDs (03) auf der Rückseite des LED-Trägers (02) umgebogen und
- zur wärmetechnischen Anbindung flach auf eine auf der Rückseite angeordnete Kontaktfläche gelegt sind.

2. Leuchte nach Anspruch 1,
**dadurch gekennzeichnet,**
**dass** der LED-Träger (02) mindestens zwei mit jeweils mindestens einer LED (03) bestückte Flächenabschnitte (07) aufweist, welche unterschiedliche Raumpositionen und/oder Raumorientierungen einnehmen.

3. Leuchte nach Anspruch 2,
**dadurch gekennzeichnet,**
**dass** die Flächenabschnitte (07) gewölbt sind bzw. gewölbt verlaufen.

4. Leuchte nach Anspruch 2 oder 3
**dadurch gekennzeichnet,**
**dass** die Flächenabschnitte (07) in sich tordiert bzw. verdreht sind bzw. in sich tordiert bzw. verdreht verlaufen.

5. Leuchte nach Anspruch 2,
**dadurch gekennzeichnet,**
**dass** die Flächenabschnitte (07) Ebenen sind.

6. Leuchte nach einem der Ansprüche 2 bis 5,
**dadurch gekennzeichnet,**
**dass** die Flächenabschnitte (07) dem Verlauf einer Lichtscheibe und/oder des Reflektors (01) der Leuchte angepasst sind.

7. Leuchte nach einem der Ansprüche 2 bis 6,
**dadurch gekennzeichnet,**
**dass** die Flächenabschnitte (07) einander schneiden.

8. Leuchte nach einem der Ansprüche 2 bis 7,
**dadurch gekennzeichnet,**
**dass** die Flächenabschnitte (07) zumindest abschnittsweise parallel verlaufen.

9. Leuchte nach einem der Ansprüche 2 bis 8,
**dadurch gekennzeichnet,**
**dass** die Flächenabschnitte (07) mit Stufen (08) miteinander verbunden sind.

10. Leuchte nach einem der vorhergehenden Ansprüche,
**dadurch gekennzeichnet,**
**dass** weitere elektronische Bauteile auf der dem Reflektor (01) abgewandten Rückseite des LED-Trägers (02) befestigt sind.

11. Leuchte nach Anspruch 10,
**dadurch gekennzeichnet,**
**dass** die weiteren elektronischen Bauteile als SMD Bauteile ausgeführt sind.

12. Leuchte nach einem der vorhergehenden Ansprüche,
**dadurch gekennzeichnet,**
**dass** die LEDs (03) spritzgegossene LEDs (03) mit speziellen Optiken sind.

13. Leuchte nach einem der vorhergehenden Ansprüche,
**dadurch gekennzeichnet,**
**dass** der Reflektor (01) und der LED-Träger (02) ein in MID-Technik hergestelltes integrales Bauteil sind.

14. Leuchte nach einem der Ansprüche 1 bis 12,
**dadurch gekennzeichnet,**
**dass** der LED-Träger (02) am Reflektor (01) befestigt oder zumindest positioniert ist.

## Claims

1. A light comprising several LEDs (03) arranged on an LED carrier (02) and a reflector (01) with several reflector chambers (04), wherein:
- a LED (03) is arranged in the focal point of each reflector chamber (04),
- the LED carrier (02) is manufactured as a plastic injection moulding part,
- the LED carrier (02) is equipped with conducting paths (06), via which the LEDs (03) are electrically contacted,
- the conducting paths (06) are arranged on the back of the LED carrier (02) facing away from the reflector (01),
- the LEDs (03) are wired LEDs (03) equipped with pins (05), and
- the LEDs (03) are electrically connected with the conducting paths (06) by means of through-contacting on the back of the LED carrier (02),
**characterised in that**:
- the LED carrier (02) is manufactured by the Molded Interconnect Devices (MID) technique with the conducting paths (06) integrated with the plastic injection moulding part,
- the LEDs (03) are soldered to the conducting paths (06),
- the pins (05) of the wired LEDs (03) are bent over on the back of the LED carrier (02) and
- are placed flat on a contact surface arranged on the back to ensure thermo-technical connection.

2. Light according to claim 1, **characterised in that**
the LED carrier (02) comprises at least two area portions (07) equipped, respectively, with at least one LED (03), which sections occupy different space positions and/or space orientations.

3. Light according to claim 2, **characterised in that**
the area portions (07) are arched or extend in an arched manner.

4. Light according to claim 2 or 3, **characterised in that**
the area portions (07) are in themselves twisted or distorted, or extend in a twisted or distorted manner.

5. Light according to claim 2, **characterised in that**
the area portions (07) are planes.

6. Light according to one of claims 2 to 5, **characterised in that**
the area portions (07) are adapted to match the development of a lens and/or the reflector (01) of the light.

7. Light according to one of claims 2 to 6, **characterised in that**
the area portions (07) intersect with each other.

8. Light according to one of claims 2 to 7, **characterised in that**
the area portions (07) extend in parallel at least in sections.

9. Light according to one of claims 2 to 8, **characterised in that**
the area portions (07) are connected with each other by steps (08).

10. Light according to one of the preceding claims, **characterised in that**
further electronic components are attached to the back of the LED carrier (02) facing away from the reflector (01).

11. Light according to claim 10, **characterised in that**
such further electronic components are implemented as SMD components.

12. Light according to one of the preceding claims, **characterised in that**
the LEDs (03) are injection-moulded LEDs (03) with special optics.

13. Light according to one of the preceding claims, **characterised in that**
the reflector (01) and the LED carrier (02) are an integral component manufactured by the MID technique.

14. Light according to one of claims 1 to 12, **characterised in that**
the LED carrier (02) is attached to or at least positioned on the reflector (01).

## Revendications

1. Luminaire comportant plusieurs LEDs (03) disposés sur un support de LED (02) et un réflecteur (01) comportant plusieurs chambres de réflecteur (04), dans lequel :
- une LED (03) est disposée dans le point focal de chaque chambre de réflecteur (04),
- le support de LED (02) est fabriqué comme une pièce moulée par injection en plastique,
- le support de LED (02) ets pourvu de pistes conductrices (06), par l'intermédiaire desquelles les LEDs (03) sont contactées électriquement,
- les pistes conductrices (06) sont disposées sur la face arrière du support de LED (02) qui se détourne du réflecteur (01),
- les LEDs (03) sont des LEDs (03) câblées, pourvues de pattes (05),
- les LEDs (03) sont reliées électriquement avec les pistes conductrices (06) au moyen d'une connexion transversale sur la face arrière du support de LED (02),
**caractérisé en ce que**
- le support de LED (02) est fabriqué selon la technique MID (Molded Interconnect Devices) avec les pistes conductrices (06) intégrées dans la pièce moulée par injection en plastique,
- les LEDs (03) sont brasées avec les pistes conductrices (06),
- les pattes (05) des LEDs câblées (03) sont rabattues sur la face arrière du support de LEDs (02) et sont posées à plate par accolage thermique sur une surface de contact disposée sur la face arrière.

2. Luminaire selon la revendication 1,
**caractérisé en ce que**
le support de LED (02) présente au moins deux portions de surface (07) garnies respectivement d'au moins une LED (03), qui adoptent des positions spatiales et/ou des orientations spatiales différentes.

3. Luminaire selon la revendication 2,
**caractérisé en ce que**
les portions de surface (07) sont bombées ou s'étendent avec un bombage.

4. Luminaire selon la revendication 2 ou 3,
**caractérisé en ce que**
les portions de surface (07) sont tordues ou vrillées, respectivement s'étendent en torsion ou en vrille.

5. Luminaire selon la revendication 2,
**caractérisé en ce que**
les portions de surface (07) sont des plans.

6. Luminaire selon une des revendications 2 à 5,
**caractérisé en ce que**
les portions de surface (07) sont adaptées au cours d'une glace de diffusion et/ou du réflecteur (01) du luminaire.

7. Luminaire selon une des revendications 2 à 6,
**caractérisé en ce que**
les portions de surface (07) se coupent l'une l'autre.

8. Luminaire selon une des revendications 2 à 7,
**caractérisé en ce que**
les portions de surface (07) s'étendant au moins en parallèle sur des portions.

9. Luminaire selon une des revendications 2 à 8,
**caractérisé en ce que**
les portions de surface (07) sont reliées les unes aux autres par des gradins (08).

10. Luminaire selon une des revendications précédentes,
**caractérisé en ce que**
d'autres composants électroniques sont fixés sur la face arrière qui se détourne du réflecteur (01) du support de LED (02).

11. Luminaire selon la revendication 10,
**caractérisé en ce que**
les autres composants électroniques sont conçus comme des composants SMD.

12. Luminaire selon une des revendications précédentes,
**caractérisé en ce que**
les LEDs (03) sont des LEDs (03) moulées par injection avec des optiques spéciales.

13. Luminaire selon une des revendications précédentes,
**caractérisé en ce que**
le réflecteur (01) et le support de LED (02) sont un composant fabriqués en un seul tenant selon la technique MID.

14. Luminaire selon une des revendications 1 à 12,
**caractérisé en ce que**
le support de LED (02) est fixé ou est au moins positionné sur le réflecteur (01.
